**Europäisches Patentamt**

**European Patent Office**

**Office européen des brevets**

(11) Publication number: **0 122 119**
**B1**

(12) **EUROPEAN PATENT SPECIFICATION**

(45) Date of publication of patent specification: **28.02.90**

(21) Application number: **84302328.4**

(22) Date of filing: **05.04.84**

(51) Int. Cl.⁵: **G 11 C 11/40**

(54) **A sense amplifier.**

(30) Priority: **07.04.83 JP 60032/83**

(43) Date of publication of application:
**17.10.84 Bulletin 84/42**

(45) Publication of the grant of the patent:
**28.02.90 Bulletin 90/09**

(84) Designated Contracting States:
**DE FR GB**

(56) References cited:
**FR-A-2 506 990**

**IBM TECHNICAL DISCLOSURE BULLETIN, vol.
16, no. 12, May 1974, pages 3960-3961, New
York, US; J. Gschwendtner et al.: "Sense
system"**

(73) Proprietor: **FUJITSU LIMITED**
**1015, Kamikodanaka Nakahara-ku
Kawasaki-shi Kanagawa 211 (JP)**

(72) Inventor: **Koshizuka, Atuo
Seiwa-so, 395, Shimokodanaka Nakahara-ku
Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to a sense amplifier, and more particularly to a complementary metal-oxide semiconductor (CMOS) high-speed sense amplifier for amplifying a potential difference between a pair of bit lines or a pair of data buses in a static semiconductor memory.

Accompanied by the recent developments in the high integration of semiconductor memories, each transistor constituting a memory cell has become more and more miniaturized. This miniaturization has reduced the driving capability of a transistor, lowered the speed of the potential change, during reading, of a pair of bit lines or a pair of data buses connected to a sense amplifier, and decreased the potential difference between a pair of bit lines or a pair of data buses. To detect the thus decreased and slowly changing potential difference between a pair of bit lines or a pair of data buses, an improved high-speed sense amplifier is necessary.

A conventional sense amplifier cannot provide high-speed operation with such a decreased and slow changing potential difference, because of the long rising period and large amplitude of the output signal, as described later in more detail.

An embodiment of the present invention can provide a sense amplifier which can operate at high speed in response to a change of potential of a pair of bit lines or a pair of data lines.

An embodiment of the present invention can also provide a sense amplifier which can change the output potential at a high speed in response to a change of potential of a pair of bit lines or a pair of data lines.

A sense amplifier according to the present invention employs two asymmetrical differential amplifiers connected to each other in such a way that their outputs are accelerated, to charge up one another by utilizing nodes at which potentials are changed in response to a change of the input signal supplied from a pair of bit lines or a pair of data lines.

According to the present invention, there is provided a sense amplifier comprising a pair of differential amplifier circuits each including a pair of differential input transistors for receiving complementary signals and a feedback transistor connected to a commonly connecting point of the pair of differential input transistors and having a control input connected to an output of one of the differential input transistors. The complementary signals applied to one of the pair of differential amplifier circuits have phases opposite to the phases of the complementary signals applied to the other of the pair of differential amplifier circuits. At least one of the pair of differential amplifier circuits has a first output pull up transistor and a second output pull up transistor connected in parallel between a power supply line and an output end. The first output pull up transistor has a control input connected to the control input of the feedback transistor. The second output pull up transistor has a control input connected to an output of the feedback transistor in the other end of the differential amplifier circuits.

Reference is made, by way of example, to the accompanying drawings in which:

Figure 1 is a circuit diagram showing a conventional sense amplifier;

Figure 2 is a circuit diagram showing part of a semiconductor memory device to which the present invention is applied;

Figure 3 is a waveform diagram showing the operation of the device shown in Figure 2;

Figure 4 is a circuit diagram showing a sense amplifier according to an embodiment of the present invention;

Figure 5 is a waveform diagram showing an example of the operation of the circuit shown in Fig. 4; and

Figure 6 is a waveform diagram showing another example of the operation of the circuit shown in Figure 4.

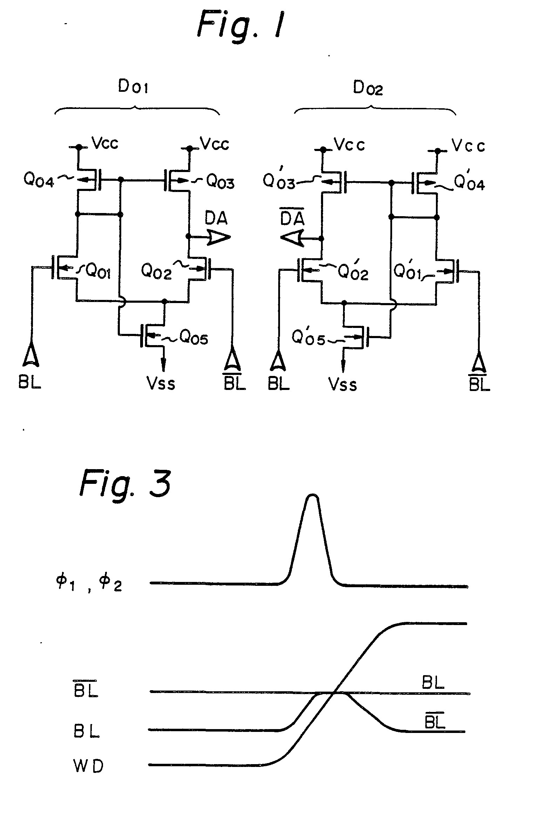

Before describing an embodiment of the present invention, a conventional sense amplifier will first be described with reference to Fig. 1. In Fig. 1, the conventional sense amplifier consists of two asymmetrical differential amplifiers $D_{01}$ and $D_{02}$. The first differential amplifier $D_{01}$ includes N-channel input transistors $Q_{01}$ and $Q_{02}$, P-channel pull-up transistors $Q_{03}$ and $Q_{04}$, and an N-channel feedback transistor $Q_{05}$. A pair of bit lines BL and $\overline{BL}$ are connected to the gates of the input transistors $Q_{01}$ and $Q_{02}$, respectively. An output signal DA is obtained at a commonly connecting point between the drain of the P-channel pull-up transistor $Q_{03}$ and the drain of the N-channel input transistor $.Q_{02}$. The second differential amplifier $D_{02}$ has the same constitution as the first sense amplifier unit $D_{01}$ and includes transistors $Q_{01}'$ through $Q_{05}'$.

When the bit line BL is at a high potential (H) and the bit line $\overline{BL}$ is at a low potential (L), in the first differential amplifier $D_{01}$, the transistor $Q_{01}$ has a high mutual conductance ($g_m$ (H)) and transistor $Q_{02}$ has a low mutual conductance $g_m$ (L). Therefore, the P-channel pull up transistor $Q_{04}$ and $Q_{05}$ receive a low potential at their gates and have high mutual conductance $g_m$ (H). Thus, the output signal DA is at a high level. The feedback transistor $Q_{05}$ receives a low potential at its gate and has low mutual conductance $g_m$ (L), ensuring the high level of the output signal DA. In contrast, in the second differential amplifier $D_{02}$, the transistors $Q_{01}'$ and $Q_{03}'$, and $Q_{04}'$ have the low mutual conductance $g_m$ (L), and the transistors $Q_{02}'$ and $Q_{05}'$ have the high mutual conductance $g_m$ (H), so that the output signal $\overline{DA}$ is at a low level.

Conversely, when the bit line BL is at a L level and the bit line $\overline{BL}$ is at an H level, it will be easily seen that the output signal DA is at an L level and the output signal $\overline{DA}$ is at an H level.

The conventional sense amplifier shown in Fig. 1 however, has a disadvantage of low-speed operation. That is, it takes a considerably long period from a time at which a pair of bit lines inverts its potential to a time at which a pair of the output potentials of the sense amplifier are inverted. This is because the output potential is raised only by the single pull-up transistor $Q_{03}$ or $Q_{03}'$, and the output potential is lowered only by the single transistor $Q_{02}$ or $Q_{02}'$. Another reason for low-speed operation is that the amplitude of the output signal DA or $\overline{DA}$, which is determined by the transistors $Q_{03}$, $Q_{02}$, and $Q_{05}$, is relatively large.

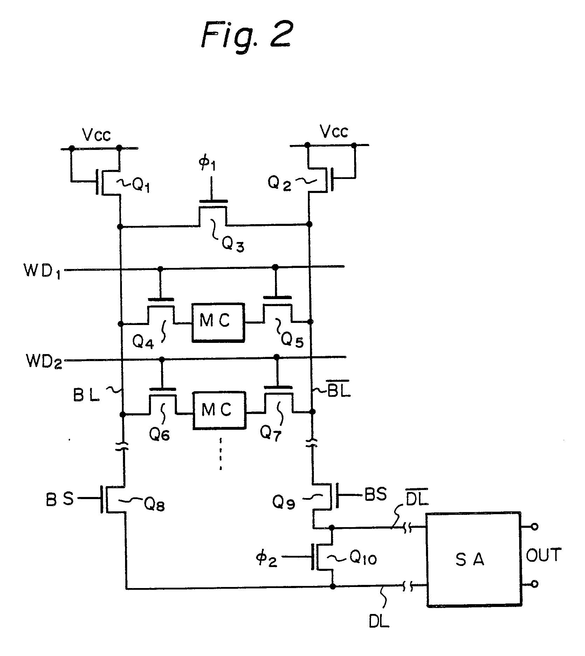

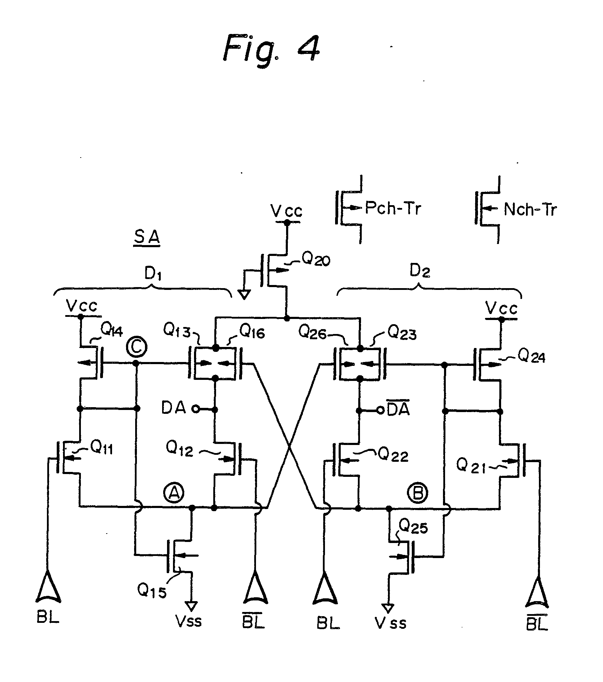

Figure 2 shows part of a semiconductor memory device to which the present invention may be applied. Fig. 3 is a waveform diagram showing the operation of the device shown in Fig. 2. Referring to Figs. 2 and 3, when clock signals $\phi_1$ and $\phi_2$ are applied to the gates of precharging transistors $Q_3$ and $Q_{10}$, bit lines BL and $\overline{BL}$, and data lines DL and $\overline{DL}$ are shortcircuited. In this example, the bit lines BL and $\overline{BL}$ are precharged through transistors $Q_1$ and $Q_2$ to have a high potential. Then, when a word line, for example, word line $WD_1$ is selected to have high potential, one of the bit lines BL and $\overline{BL}$, for example, $\overline{BL}$, is turned to a low potential, depending on the contents of a selected memory cell. The potential of the other bit line BL is not changed in this example. After this, when a bit-line selecting signal BS is applied to the gates of transfer-gate transistors $Q_8$ and $Q_9$, the potentials of the bit lines BL and $\overline{BL}$ are transferred through the transistors $Q_8$ and $Q_9$ to the data lines DL and $\overline{DL}$. A sense amplifier SA amplifies the potential difference between the data lines DL and $\overline{DL}$. According to the present invention, the sense amplifier SA is improved, as later described in detail.

Another example of a semiconductor memory device is known in which a pair of bit lines are precharged to have an intermediate potential between a high potential and a low potential.

As will be described later in more detail, the present invention is effective whether a pair of bit lines are precharged to have a high potential or to have an intermediate potential.

An embodiment of the present invention will now be described in detail.

Figure 4 is a circuit diagram showing a sense amplifier according to an embodiment of the present invention. In Fig. 4, a sense amplifier SA consists of a first differential amplifier $D_1$ and a second differential amplifier $D_2$. The first differential amplifier $D_1$ comprises a first input transistor $Q_{11}$, a second input transistor $Q_{12}$, a first output pull up transistor $Q_{13}$, a pull up transistor $Q_{14}$, a feedback transistor $Q_{15}$, and a second output pull up transistor $Q_{16}$. In this embodiment, the transistors $Q_{13}$, $Q_{14}$, and $Q_{16}$ are P channel metal-oxide semiconductor (MOS) transistors, and the transistors $Q_{11}$, $Q_{12}$, and $Q_{15}$ are N channel MOS transistors. A bit line BL is connected to the gate of the first input transistor $Q_{11}$. A bit line $\overline{BL}$ is connected to the gate of the second input transistor $Q_{12}$. The drain of the first input transistor $Q_{11}$ is connected to the gate and the drain of the pull up transistor $Q_{14}$, to the gate of the first output pull up transistor $Q_{13}$, and to the gate of the feedback transistor $Q_{15}$. The source of the pull up transistor $Q_{14}$ is connected to a power supply $V_{CC}$. The drains of the first and the second output pull up transistors $Q_{13}$ and $Q_{16}$ are connected to the drain of the second input transistor $Q_{12}$. The sources of the first and the second input transistors $Q_{11}$ and $Q_{12}$ are connected to the drain of the feedback transistor $Q_{15}$. The source of the feedback transistor $Q_{15}$ is connected to a ground line $V_{SS}$. An output end DA is connected to a point between the drains of the output pull up transistor $Q_{13}$ or $Q_{16}$ and the second input transistor $Q_{12}$.

The second output pull up transistor $Q_{16}$ is provided according to the present invention.

The circuit constitution of the second differential amplifier $D_2$ may be similar to that of the first differential amplifier $D_1$, and includes a first input transistor $Q_{21}$, a second input transistor $Q_{22}$, a first output pull up transistor $Q_{23}$, a pull up transistor $Q_{24}$, a feedback transistor $Q_{25}$, and a second output pull up transistor $Q_{26}$. It should be noted, however, that, in contrast to the first differential amplifier $D_1$, the second differential amplifier $D_2$ receives a signal on the bit line BL at the gate of the second input transistor $Q_{22}$ and receives a signal on the bit line $\overline{BL}$ at the gate of the first input transistor $Q_{21}$. The signals on the bit lines BL and $\overline{BL}$, after the bit lines are selected, are complementary. The above-mentioned contrast lies in the fact that the complementary signals applied to the first differential amplifier $D_1$ have opposite phases to the complementary signals applied to the second differential amplifier $D_2$.

In this embodiment of the present invention, an output amplitude determining transistor $Q_{20}$ is provided between the sources of the output pull up transistors $Q_{13}$, $Q_{16}$, $Q_{23}$, and $Q_{26}$ and the power supply $V_{CC}$. The transistor $Q_{20}$ in this embodiment is a P-channel MOS transistor. The source of the transistor $Q_{20}$ is connected to the power supply $V_{CC}$. The drain of the transistor $Q_{20}$ is connected to the sources of the transistors $Q_{13}$, $Q_{16}$, $Q_{23}$, and $Q_{26}$. The gate of the transistor $Q_{20}$ is grounded. Accordingly, the transistor $Q_{20}$ is normally in a conductive state.

The sources of the input transistors $Q_{11}$ and $Q_{12}$ in the first differential amplifier $D_1$ are connected to the gate of the second output pull up transistor $Q_{26}$ in the second differential amplifier $D_2$. The sources of the input transistors $Q_{21}$ and $Q_{22}$ are connected to the gate of the second pull up transistor $Q_{16}$ in the first differential amplifier $D_1$.

Thus, the first differential amplifier $D_1$ and the second differential amplifier $D_2$ each constitute a complementary MOS (CMOS) differential amplifier having P channel output pull up transistors and N channel input transistors.

The second output pull up transistors $Q_{16}$ and $Q_{26}$ function to accelerate the charging up of the output ends DA and $\overline{DA}$, respectively.

As will be apparent by comparing Figures 1 and 4, the conventional sense amplifier shown in Fig. 1 is equivalent to the circuit in which the second output pull up transistors $Q_{16}$ and $Q_{26}$ and the

output amplitude determining transistors $Q_{20}$ are removed from the circuit shown in Fig. 4.

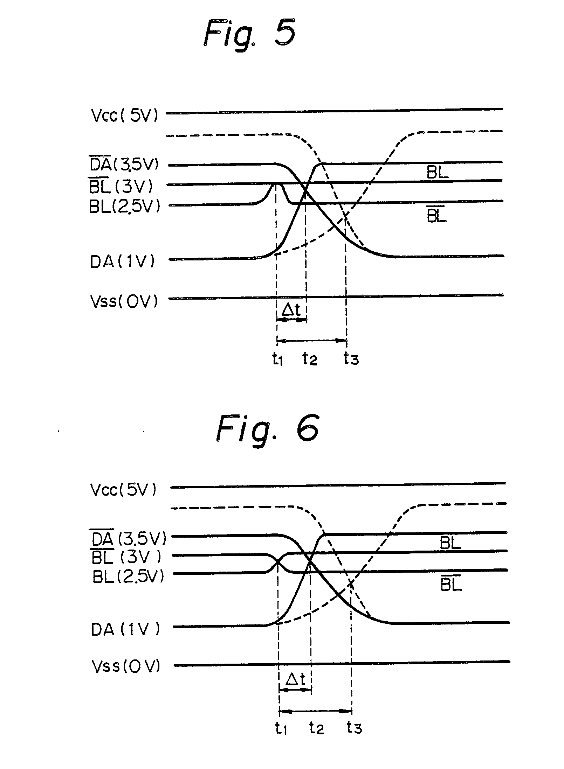

Figure 5 is a waveform diagram showing an example of the operation of the circuit shown in Fig. 4. In Fig. 5, the potential of the power supply $V_{CC}$ is assured to be about 5 V, and the potential of the ground line $V_{SS}$ is assumed to be about 0 V. Initially, it is assumed that the bit line BL is at the low potential (L level) of about 2.5 V, and the bit line $\overline{BL}$ is at the high potential (H level) of about 3 V. Because of the miniaturization of memory cells as mentioned before, the potential difference between bit lines may be as small as 0.5 V. By applying the L level to the gate of the first input transistor $Q_{11}$ in the first differential amplifier, the first input transistor $Q_{11}$ has a low mutual conductance $g_m$ (L), so that the potential at a node Ⓒ connected to the gates of the transistors $Q_{13}$ and $Q_{14}$ is at a high level, causing the P-channel transistors $Q_{13}$ and $Q_{14}$ to have a low mutual conductance $g_m$ (L), and causing the N-channel feedback transistor $Q_{15}$ to have a high mutual conductance $g_m$ (H). Also, because the H level is applied to the gate of the second input transistor $Q_{12}$, it has a high mutual conductance $g_m$ (H).

On the other hand, in the second differential amplifier, the first input transistor $Q_{21}$ has the high mutual conductance $g_m$ (H) and, accordingly,. the P-channel transistors $Q_{23}$ and $Q_{24}$ have the high mutual conductance $g_m$ (H). The feedback transistor $Q_{25}$ has the low mutual conductance $g_m$ (L). The second input transistor $Q_{22}$ has the low mutual conductance $g_m$ (L).

Since the feedback transistor $Q_{25}$ has the low mutual conductance $g_m$ (L), the potential at a node Ⓑ connected to the drain of transistor $Q_{25}$ is at a high level. The node Ⓑ is connected to the gate of the second output pull up transistor $Q_{16}$ in the first differential amplifier $D_1$. Therefore transistor $Q_{16}$ has the low mutual conductance $g_m$ (L). As a result, in the first differential amplifier $D_1$, transistors $Q_{13}$ and $Q_{16}$ have the low mutual conductance $g_m$ (L), and transistors $Q_{12}$ and $Q_{15}$ have the high mutual conductance $g_m$ (H), so that the potential at the output end DA is at a low level of about 1 V.

Since the feedback transistor $Q_{15}$ has the high mutual conductance $g_m$ (H), the potential at a node Ⓐ connected to the drain of the transistor $Q_{15}$ is at a low level. The node Ⓐ is connected to the gate of the second output pull up transistor $Q_{26}$ in the second differential amplifier $D_2$. Therefore, transistor $D_{26}$ has the high mutual conductance $g_m$ (H). As a result, in the second differential amplifier $D_2$, the transistors $Q_{23}$ and $Q_{26}$ have the high mutual conductance $g_m$ (H), and the transistors $Q_{22}$ and $Q_{25}$ have the low mutual conductance $g_m$ (L), so that the potential at the output end $\overline{DA}$ is at a high level of about 3.5 V.

At a time $t_1$, the pair of bit lines BL and $\overline{BL}$ are precharged to the same potential of 3 V. By this precharging, the transistors $Q_{11}$, $Q_{13}$ and $Q_{14}$ in the first differential amplifier $D_1$, and the transistor $Q_{22}$ in the second differential amplifier $D_2$ change to having high mutual conductance $g_m$

(H). Also, the transistor $Q_{15}$ changes to low mutual conductance $g_m$ (L).

Then the potentials of the bit lines BL and $\overline{BL}$ are inverted in accordance with the content of the selected memory cell, so that the bit line BL is kept at the high potential of 3 V and the bit line $\overline{BL}$ is turned to the low potential of 2.5 V. Since the feedback transistor $Q_{15}$ has, at this stage, the low mutual conductance $g_m$ (L), the potential at the node Ⓐ is raised so that the mutual conductance of the transistor $Q_{26}$ is lowered. On the other hand, in the second differential amplifier $D_2$, transistors $Q_{21}$, $Q_{23}$, and $Q_{24}$ have, at this stage, the low mutual conductance $g_m$ (L), and the transistors $Q_{22}$ and $Q_{25}$ have the high mutual conductance $g_m$ (H). As a result, the potential at the node Ⓑ is lowered so that the mutual conductance of the transistor $Q_{16}$ for accelerating the charging of the output end DA is increased. Note, the potential at node Ⓑ is lower than the potential at node Ⓒ which is also at a low level. Therefore, the second output pull up transistor $Q_{16}$ becomes more active than the first output pull up transistor $Q_{13}$. As a result, the second output pull up transistor $Q_{16}$ is rapidly turned more conductive, accelerating the charge up of the output end DA to the high level of about 3.5 V.

In the second differential amplifier $D_2$, the transistors $Q_{23}$ and $Q_{26}$ are turned to have the low mutual conductance $g_m$ (L) and the transistors $Q_{22}$ and $Q_{25}$ are turned to have the high mutual conductance $g_m$ (H), so that the charges stored at the output end $\overline{DA}$ are discharged through the transistors $Q_{22}$ and $Q_{25}$ to the ground line $V_{SS}$. Thus, the potential at the output end $\overline{DA}$ gradually decreases, and as a result, at a time $t_2$, the potentials at the output ends DA and $\overline{DA}$ are inverted.

It will be seen from Fig. 5 that a period $\Delta t$ between the time $t_1$ and the time $t_2$ is a response period of the sense amplifier SA in response to an inversion of the bit lines. The response period $\Delta t$ is shortened in comparison with the conventional response period. One reason for this is because the rise of the potential at the output end DA is accelerated by the function of the second output pull up transistor $Q_{16}$. Another reason is that the high level of potential at the output end DA is limited to a relatively low voltage of about 3.5 V by providing the output amplitude determining transistor $Q_{20}$. The high level of potential at the output end DA is adjustable by varying the dimensions of the transistors $Q_{16}$ and $Q_{20}$.

The operation of the sense amplifier SA in response to a potential change of the bit line BL from the high level to the low level is similar to the operation described above.

In the conventional sense amplifier shown in Fig. 1, which does not have a second output pull up transistor ($Q_{16}$ or $Q_{26}$) nor an output amplitude determining transistor $Q_{20}$, the potential at the output end DA rises in response to the increase of the mutual conductance of the transistor $Q_{03}$ and to the decrease of the mutual conductance of the transistor $Q_{02}$. However, as illustrated by a dash curve in Fig. 5, the rise of the potential at the output end DA is very slow and the high level is higher in comparison with the embodiment of the present invention. This is due to the lack of a second output pull up transistor $Q_{16}$ (or $Q_{26}$) and also the lack of an output amplitude determining transistor $Q_{20}$. Therefore, a time $t_3$, at which the potentials of the output ends DA and $\overline{DA}$ of the dash curves cross, is later than the time $t_2$ in the embodiment of the present invention.

More precisely, in the conventional sense amplifier shown in Fig. 1, when the bit lines BL and $\overline{BL}$ are precharged to a high potential of about 3 V, the transistors $Q_{01}$, $Q_{02}$, $Q_{03}$, and $Q_{04}$ have high mutual conductance $g_m$ (H), and the transistor $Q_{05}$ has low mutual conductance $g_m$ (L). Then when the potential of the bit line $\overline{BL}$ is lowered, the transistor $Q_{02}$ changes to low mutual conductance $g_m$ (L). As a result, the potential at the output end DA is pulled up through the transistor $Q_{03}$. Therefore, only the second input transistor $Q_{02}$ changes its state to assist the rise of the potential at the output end DA. No acceleration to raise the output potential is carried out in the conventional sense amplifier.

Figure 6 is a waveform diagram showing another example of the operation of the circuit shown in Fig. 4. In Fig. 6, the only difference from Fig. 5 is that the pair of bit lines BL and $\overline{BL}$ are precharged not to the high level of about 3 V but to an intermediate level between 3 V and 2.5 V. The operation of the sense amplifier SA in this case is similar to that described with reference to Fig. 5, and therefore, is not described here.

The present invention is not restricted to the above-described embodiment. Various changes and modifications are possible. For example, in place of the CMOS asymmetrical differential amplifier, any other type of asymmetrical differential amplifier may be employed within the scope of the present invention.

From the foregoing description, it will be apparent that, according to an embodiment of the present invention, by employing two asymmetrical differential amplifiers which may have the same circuit configuration, and by connecting them so as to accelerate charging up of the outputs of the asymmetrical differential amplifiers by utilizing nodes whose potentials are changed in response to changes of input potentials, a sense amplifier according to the present invention can change its output potential at a higher speed that the conventional sense amplifier.

## Claims

1. A sense amplifier comprising
a pair of differential amplifier circuits ($D_1$, $D_2$) each including a pair of differential input transistors ($Q_{11}$, $Q_{12}$, $Q_{21}$, $Q_{22}$) for receiving complementary signals (BL, $\overline{BL}$) and a feedback transistor ($Q_{15}$, $Q_{25}$) connected to a common connecting point (A, B) of said pair of differential input transistors and having a control input connected to an output of one of said differential input transistors,
said complementary signals applied to one of said pair of differential amplifier circuits having phases opposite to the phases of said complementary signals applied to the other end of said pair of differential amplifier circuits,
at least one of said pair of differential amplifier circuits having a first output pull up transistor ($Q_{13}$, $Q_{23}$) and a second output pull up transistor ($Q_{16}$, $Q_{26}$) connected in parallel between a power supply line and a output end (DA, $\overline{DA}$),
said first output pull up transistor having a control input connected to said control input of said feedback transistor,
said second output pull up transistor ($Q_{16}$, $Q_{26}$) having a control input connected to an output of said feedback transistor in said other one of differential amplifier circuits.

2. A sense amplifier as set forth in claim 1, wherein said differential input transistors and said feedback transistor are N channel MOS transistors, and said first output pull up transistor and said second output pull up transistor are P channel MOS transistors.

3. A sense amplifier as set forth in claim 2, wherein one of said differential input transistors ($Q_{12}$, $Q_{22}$ has a drain connected to said output end.

4. A sense amplifier as set forth in claim 2 or 3, further comprising an output amplitude determining transistor ($Q_{20}$) connected between the source of said second output pull up transistor and said power supply line.

5. A sense amplifier as set forth in claim 2, 3 or 4, further comprising a P channel MOS transistor ($Q_{14}$, $Q_{24}$) having a source connected to said power supply line, a drain connected to the drain of one of said differential input transistors ($Q_{11}$, $Q_{21}$), and a gate connected to the gate of said first output pull up transistor ($Q_{13}$, $Q_{23}$).

6. A sense amplifier as set forth in claim 2, 3, 4 or 5, wherein the source of said feedback transistor ($Q_{15}$, $Q_{25}$) is connected to a ground line.

7. A sense amplifier as set forth in claim 4, wherein said output amplitude determining transistor is a P channel MOS transistor having a gate connected to a ground line.

## Patentansprüche

1. Leserverstärker mit
einem Paar von Differentialverstärkerschaltungen ($D_1$, $D_2$), die jeweils ein Paar von Differentialeingangstransistoren ($Q_{11}$, $Q_{12}$, $Q_{21}$, $Q_{22}$) zum Empfangen von komplementären Signalen (BL, $\overline{BL}$) une einen Rückkopplungstransistor ($Q_{15}$, $Q_{25}$) umfassen, die mit einem gemeinsamen Verbindungspunkt (A, B) des genannten Paares von Differentialeingangstransistoren verbunden sind und einen Steuereingang haben, der mit einem Ausgang von einem der genannten Differentialeingangstransistoren verbunden ist,
wobei die genannten komplementären Signale, die einer der Differentialverstärkerschaltungen des genannten Paares zugeführt werden, Phasen haben, die entgegengesetzt zu den Phasen der genannten komplementären Signale sind, welche der anderen Differentialverstärkerschaltungen des genannten Paares zugeführt werden,

wobei wenigstens einer Differentialverstärkerschaltungen des genannten Paares einen ersten Ausgangs-pull-up-Transistor ($Q_{13}$, $Q_{23}$) und einen zweiten Ausgangs-pull-up-Transistor ($Q_{16}$ $Q_{26}$) hat, die parallel zwischen einer Energieversorgungsleitung zu einem Ausgangsende (DA, $\overline{DA}$) verbunden sind,

der genannte erste Ausgangs-pull-up-Transistor einen Kontrolleingang hat, der mit dem genannten Kontrolleingang des genannten Rückkopplungsstransistors verbunden ist,

der genannte zweite Ausgangs-pull-up-Transistor ($Q_{16}$, $Q_{26}$) einen Steuereingang hat, der mit einem Ausgang des genannten Ruckkopplungstransistors in der genannten anderen der Differentialverstärkerschaltungen verbunden ist.

2. Leseverstärker nach Anspruch 1, bei dem die genannten Differentialeingangstransistoren und der genannte Rückkopplungstransistor N-Kanal-MOS-Transistoren sind, und der genannte erste Ausgangs-pull-up-Transistor und der genannte zweite Ausgangs-pull-up-Transistor P-Kanal-MOS-Transistoren sind.

3. Leseverstärker nach Anspruch 2, bei dem einer der genannten Differentialeingangstransistoren ($Q_{12}$, $Q_{22}$) ein Drain hat, das mit dem genannten Ausgangsende verbunden ist.

4. Leseverstärker nach einem der Ansprüche 2 oder 3, ferner mit einem die Ausgangsamplitude bestimmenden Transistor ($Q_{20}$), der zwischen der Source des genannten Ausgangs-pull-up-Transistor und der genannten Energieversorgungsleitung verbunden ist.

5. Leseverstärker nach einem der Ansprüche 2, 3 oder 4, ferner mit einem P-Kanal-MOS-Transistor ($Q_{14}$, $Q_{24}$), der eine Source hat, die mit der genannten Energieversorgungsleitung verbunden ist, ein Drain, das mit dem Drain von einem der genannten Differentialeingangstransistoren ($Q_{11}$, $Q_{21}$) verbunden ist, und ein Gate, das mit dem Gate des genannten ersten Ausgangs-pull-up-Transistors ($Q_{13}$, $Q_{23}$) verbunden ist.

6. Leseverstärker nach einem der Ansprüche 2, 3, 4 oder 5, bei dem die Source des genannten Rückkopplungstransistors ($Q_{15}$, $Q_{25}$) mit einer Erdleitung verbunden ist.

7. Leseverstärker nach Anspruch 4, bei dem der genannte die Ausgangsamplitude bestimmende Transistor ein P-Kanal-MOS-Transistor ist, der ein Gate hat, das mit einer Erdleitung verbunden ist.

**Revendications**

1. Amplificateur de lecture comportant:
une paire de circuits d'amplificateurs différentiels ($D_1$, $D_2$) comprenant chacun une paire de transistors d'entrée différentiels ($Q_{11}$, $Q_{12}$, $Q_{21}$, $Q_{22}$) destinés à recevoir des signaux complémentaires (BL, $\overline{BL}$) et un transistor de réaction ($Q_{15}$, $Q_{25}$) connecté à un point de connexion commun (A, B) de ladite paire de transistors d'entrée différentiels et ayant une entrée de commande connectée à une sortie de l'un desdits transistors d'entrée différentiels,

lesdits signaux complémentaires appliques à l'un de ladite paire de circuits d'amplificateurs différentiels ayant des phases opposées aux phases desdits signaux complémentaires appliqués à l'autre de ladite paire de circuits d'amplificateurs différentiels,

l'un au moins de ladite paire de circuits d'amplificateurs différentiels comprennant un premier transistor élévateur de tension de sortie ($Q_{13}$, $Q_{23}$) et un second transistor élévateur de tension de sortie ($Q_{16}$, $Q_{26}$) connecté en parallèle entre une ligne d'alimentation et une extrémité de sortie (DA, $\overline{DA}$),

ledit premier transistor élévateur de tension de sortie ayant une entrée de commande connectée à ladite entrée de commande dudit transistor de réaction,

ledit second transistor élévateur de tension de sortie ($Q_{16}$, $Q_{26}$) ayant une entrée de commande connectée à une sortie dudit transistor de réaction de l'autre desdits circuits amplificateurs différentiels.

2. Amplificateur de lecture selon la revendication 1, dans lequel lesdits transistors d'entrée différentiels et ledit transistor de réaction sont des transistors MOS à canal N, et ledit premier transistor élévateur de tension de sortie et ledit second transistor élévateur de tension de sortie sont des transistors MOS à canal P.

3. Amplificateur de lecture selon la revendication 2, dans lequel l'un desdits transistors d'entrée différentiels ($Q_{12}$, $Q_{22}$) comporte un drain connecté à ladite extrémité de sortie.

4. Amplificateur de lecture selon la revendication 2 ou 3, comportant en outre un transistor de détermination d'amplitude et de sortie ($Q_{20}$) connecté entre la source dudit second transistor élévateur de tension de sortie et ladite ligne d'alimentation.

5. Amplificateur de lecture selon la revendication 2, 3 ou 4, comportant en outre un transistor MOS à canal P ($Q_{14}$, $Q_{24}$) comprenant une source connectée à ladite ligne d'alimentation, un drain connecté au drain de l'un desdits transistors d'entrée différentiels ($Q_{11}$, $Q_{21}$) et une grille connectée à la grille dudit premier transistor élévateur de tension de sortie ($Q_{13}$, $Q_{23}$).

6. Amplificateur de lecture selon la revendication 2, 3, 4 ou 5, dans lequel la source dudit transistor de réaction ($Q_{15}$, $Q_{25}$) est connectée à une ligne de masse.

7. Amplificateur de lecture selon la revendication 4, dans lequel ledit transistor de détermination d'amplitude de sortie est un transistor MOS à canal P dont la grille est connectée à une ligne de masse.

## Fig. 1

## Fig. 3

EP 0 122 119 B1

Fig. 2

2

# Fig. 4

# Fig. 5

Vcc(5V)

DA(3.5V)
BL(3V)
BL(2.5V)                    BL
                            BL

DA(1V)

Vss(0V)

Δt

t1  t2  t3

# Fig. 6

Vcc(5V)

DA(3.5V)
BL(3V)
BL(2.5V)                    BL
                            BL

DA(1V)

Vss(0V)

Δt

t1  t2  t3